# EUROPEAN PATENT SPECIFICATION

(11) **EP 2 418 769 B1**
(45) Date of publication and mention of the grant of the patent: **04.09.2013**
(21) Application number: 10290409.1
(22) Date of filing: 20.07.2010
(51) Int. Cl.: H03F 3/72, H03F 3/193, H03F 3/24, H01P 5/12

(54) **Power amplifier for mobile telecommunications**
Leistungsverstärker für mobile Telekommunikation
Amplificateur de puissance pour télécommunications mobiles

(43) Date of publication of application: 15.02.2012
(73) Proprietor: Alcatel Lucent, 75007 Paris (FR)
(72) Inventor: Grebennikov, Andrei, Dublin 15 (IE)
(74) Representative: Sarup, David Alexander

(56) References cited:
- EP-A1- 2 169 823
- US-A1- 2005 024 136
- US-A1- 2009 039 966
- US-A1- 2009 201 084
- HIROSHI OKAZAKI ET AL: "Efficient High Power Amplifiers with Transmission Power Control Function", EUROPEAN MICROWAVE CONFERENCE, 1999. 29TH, IEEE, PISCATAWAY, NJ, USA, 1 October 1999 (1999-10-01), pages 275-278, XP031067217,
- PAUL SAAD ET AL: "An inverse class-F GaN HEMT power amplifier with 78% PAE at 3.5 GHz", MICROWAVE CONFERENCE, 2009. EUMC 2009. EUROPEAN, IEEE, PISCATAWAY, NJ, USA, 29 September 2009 (2009-09-29), pages 496-499, XP031670297, ISBN: 978-1-4244-4748-0
- GUNTUPALLI A B ET AL: "Compact high performance microstrip dual-band bandstop filters for GSM mobile bands", ELECTROMAGNETIC INTERFERENCE&COMPATIBILITY, 2008. INCEMIC 2008. 10TH INTERNATIONAL CONFERENCE ON, IEEE, PISCATAWAY, NJ, USA, 26 November 2008 (2008-11-26), pages 69-71, XP031483708, ISBN: 978-81-903575-1-7
- YONG-SUB LEE ET AL: "A wideband GaN HEMT distributed power amplifier for WiMAX applications", MICROWAVE CONFERENCE, 2008. APMC 2008. ASIA-PACIFIC, IEEE, PISCATAWAY, NJ, USA, 16 December 2008 (2008-12-16), pages 1-4, XP031458046, ISBN: 978-1-4244-2641-6

## Description

### Field of the Invention

The present invention relates to a power amplifier employed in mobile telecommunications systems.

### Background Art

In mobile telecommunication systems it is required that an RF power amplifier in a mobile base station should operate with high efficiency and high linearity simultaneously. "Efficiency" is regarded as the ratio of RF transmission output power to DC input power. "Linearity" has various measures, but a common measure is ACLR - adjacent channel power leakage ratio. There is a trade off between efficiency and linearity, with improvement in one coming at the expense of another. Many wireless communications systems, such as GSM/EDGE, CDMA2000, or WCDMA/LTE, require that the power amplifier should deliver a wide range of output powers. As a result, being designed for the highest power level with maximum available efficiency, power amplifiers in base stations tend to operate less efficiently at lower power levels, consuming a lot of extra dc power. Therefore, there is a challenge to design a base station power amplifier having high efficiency and high linearity not only at maximum output power but also at lower power levels typically ranging from -3 dB and less.

US Patent No. 7,538,609 describes RF power amplifiers wherein an input signal is fed to first, second and third amplification paths in parallel, which are selectively switched into operation. In one form, in a first mode of operation, the input signal is fed via a hybrid coupler, and the amplified signals of the first and second paths are combined to provide a high power output signal. In a second mode of operation, the first and second amplification paths are switched off, and a third low power amplification path is switched into operation. However a problem with this amplifier arises in that maximum efficiency can be achieved at two output power levels only (maximum power and backoff power determined by the third amplification path).

EP-A-2169823 discloses three separate amplifying paths with differing power levels comprising two high power paths and one low power path, each high power path comprising input and output hybrids, between which three amplifiers are coupled in a "parallel" configuration.

US2009/201084 discloses an amplifying system that has different amplifying paths for different mobile standards, GSM, WCMDA, and that furthermore different paths are provided for different frequency uplink and downlink paths. There is shown various amplifier arrangements including an amplifier stage including 3 separate amplifying chains from an initial power amplifier and the output signals from the chains being routed to an external filter.

Hiroshi Okazaki et al.- "Efficient High Power Amplifiers with Transmission Power Control Function", European Microwave Conference 1999, 29th IEEE, pages 275 to 278 discloses a schematic diagram of a conceptual generalised configuration of a power amplifier having (n) amplifying paths which may be selectively switched on. However, the only specific implementation is of two amplifying paths, and there is no teaching of how to implement a practical 3 path amplifier.

### Summary of the Invention

The present invention provides an RF power amplifier for mobile telecommunications including first, second and third amplifying paths, which provide respective first, second and third power output levels, which power output levels are different from each other, and switching means for selectively switching said amplifying paths, so that in operation, one of said amplifying paths is operative at any one time, and the others of said amplifying paths are inoperative, wherein each said amplifying path has an input and output and includes a transistor amplifier, a power divider means disposed between a power amplifier input and the inputs of said amplifying paths, the outputs of said amplifying paths being coupled through an impedance network to a power amplifier output, wherein said impedance network includes a respective phase offset transmission line coupled to the output of each amplifying path, for adjusting output phase values of the amplifying path, and the phase offset lines being coupled to said power amplifier output by way of at least one transmission line length, said at least one transmission line length being arranged for coupling the amplifying path outputs to ground via an open circuit impedance.

Advantages, at least of embodiments of the invention, are that maximum efficiency of the RF power amplifier is maintained over a wide range of power output levels, and that the efficiency of the amplifier is not reduced at backoff powers because of internal RF reflections, in contrast to the amplifiers of US Patent No. 7,538,609.

In an embodiment, the power ratios between the amplifying paths may be for example 1: 0.25: 0.1, enabling time scheduling of a base station power amplifier for anticipated power requirements, and permitting maximum efficiency of the RF power amplifier to be maintained over a wide range of power output levels.

The switching of said amplifying paths may be effected by specific switches in the main current paths, but since this may introduce extra and undesirable complications, a preferred method of switching off the amplifying paths is to change the gate bias on a power transistor in an amplifying path, in order to switch off the transistor.

Said impedance network has a main function for ensuring that correct impedance values are present at the power amplifier output, in the situation where the amplifying paths are switched on or off, so that reflection losses within the amplifier are at least reduced. The impedance network includes respective phase offset transmission lines coupled in series between each amplifying path output and the power amplifier output. In addition the network may include a quarter wavelength long transmission line stub coupled between an amplifying path output and ground reference, for stability, by suppressing to ground all potential low-frequency components, as well as for spectral purity by additional suppressing of second-harmonic components, for which the quarter-wavelength line becomes half wavelength. Whilst it would be possible to provide a separate quarter wavelength transmission line stub for each amplifying path output, it is convenient, as described herein, to connect one or more half wavelength transmission line stubs to the quarter wavelength transmission line stub, to form a chain, amplifying path outputs and phase offset lines being connected to nodes of the chain.

Such transmission lines are conveniently constructed from microstrip, microstrip being a form of construction material comprising a ground plane on one side of a dielectric substrate, and circuit elements on the other. The length of the strip determines the phase and impedance variation, and the width of the strip determines characteristic impedance. Alternatively the impedance network could if desired be provided by lumped impedances.

As regards the phase offset line, the precise length determines phase offset, but no impedance variation is caused, because of characteristic impedances connected to the two ends of the phase offset line. The network serves to provide a high output impedance of a transistor power amplifier when it is turned off and to compensate for effect of output matching elements and phase delays within the transistor power amplifiers and to provide full power when the transistor amplifier is switched on.

In further embodiments of the invention, more than three amplifying paths may be provided to provide multiple peak efficiencies at different backoff powers, depending on the number of the parallel-connected power amplifiers, each designed for certain output power.

### Brief Description of the Drawings

Embodiments of the invention will now be described, by way of example only, with reference to the accompanying drawings, wherein:
Figure 1 is a schematic block diagram of a first embodiment of an RF power amplifier according to the invention;
Figure 2 is a schematic diagram of efficiency of the amplifier of Figure 1 for various output powers;
Figure 3 is a schematic block diagram of a second embodiment of an RF power amplifier according to the invention;
Figure 4 is a schematic block diagram of a third embodiment of an RF power amplifier according to the invention;
Figure 5 is a schematic circuit diagram of an uneven power divider for use in the above embodiments; and
Figure 6 is a schematic electrical circuit diagram of a transistor power amplifier employed in the above embodiments.

### Description of the Embodiments

In the Figures, similar parts are denoted by the same reference sign.

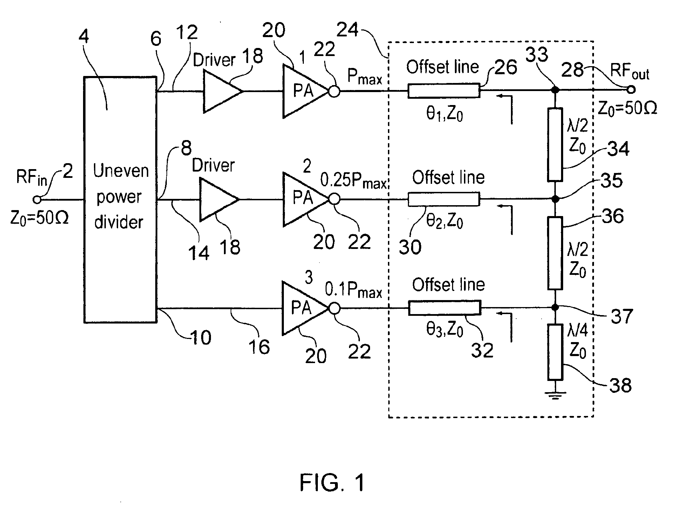

In a first embodiment shown in Figure 1. an RF power amplifier comprises an RF input 2 coupled to an uneven power divider 4, which provides three outputs coupled to respective inputs 6, 8, 10 of respective first, second and third amplifying paths 12, 14, 16. Divider 4 provides power outputs in the ratios 1: 0.25: 0.1 (in decibel terms 1: -6: -10) to respective paths 12, 14, 16.

Amplifying path 12 comprises a driver amplifier 18 coupled in series to a power amplifier 20, having an output 22 of 50Ω, coupled via an impedance network 24 to an RF power amplifier output 28 of 50Ω. Network 24 includes a phase offset line 26, for adjusting output phase, coupled between output 22 and output 28. Amplifying path 14 comprises a driver amplifier 18 coupled in series to a power amplifier 20, having an output 22 coupled to a phase offset line 30 of network 24. Amplifying path 16 comprises a power amplifier 20, having an output 22 coupled to a phase offset line 32 of network 24. Impedance network 24 additionally includes a chain of transmission line stubs 34, 36, 38 coupled between RF output 28 and ground reference, for isolating purposes. Stub 38 is a quarter wave line which, being connected to ground, provides an open circuit impedance at a node 37 between stubs 36, 38, to which offset line 32 is connected. Stub 36 is a half wavelength line, and therefore reflects this open circuit impedance at a node 35 between stubs 34, 36, to which offset line 30 is connected. Stub 34 is a half wavelength line, and therefore again reflects this open circuit impedance at a node 33, to which offset line 26 and RF output 28 are connected. Thus, for an amplifier 20 in amplifying path 14 or 16, which is switched on, the half-wave lines 34, 36 directly connect its 50Ω output to the output port 28 without any impedance transformation.

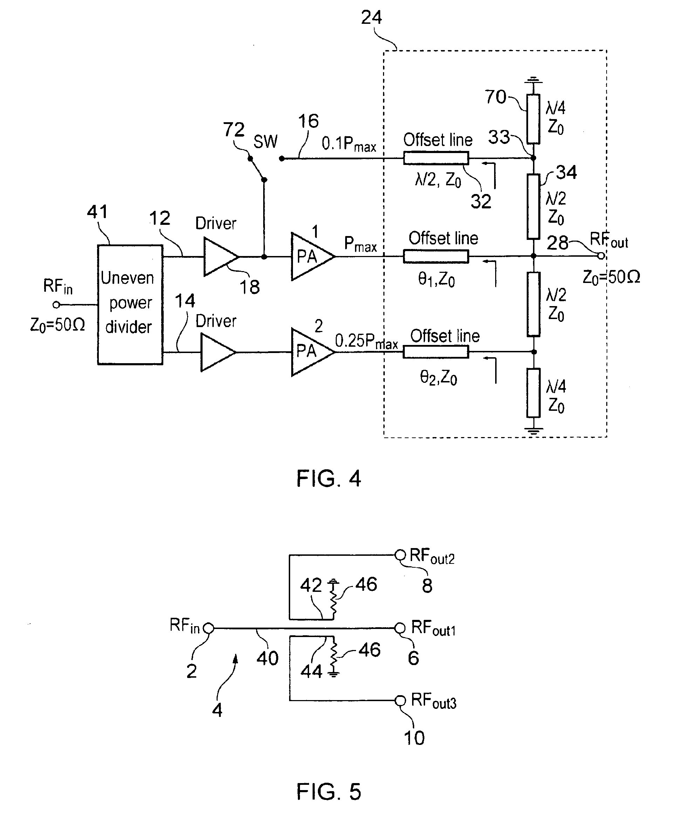

A specific form of uneven power divider 4 is shown in Figure 5, wherein an RF line 40 is directly connected between input 2 and output 6. Outputs 8, 10 are coupled to RF line 40 via lines 42, 44 spaced predetermined distances from line 40, in order to provide predetermined coupling coefficients therebetween, and to determine the amount of power coupled to the outputs 8, 10. Lines 42, 44 are also coupled to ground via resistors 46. Thus output 6 provides maximum power output, output 8 is coupled to provide 0.25 of this maximum, and output 10 is coupled to provide 0.1 of this power output.

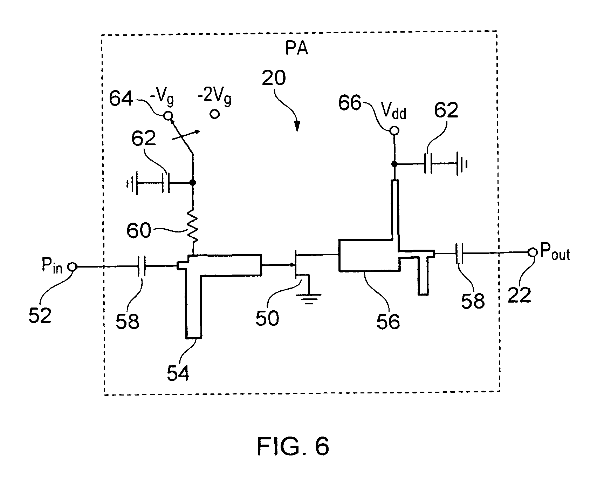

Referring to Figure 6, an electrical circuit diagram of the construction of transistor power amplifier 20, a single GaN HEMT power transistor 50 is coupled to an input port 52 via an input matching microstrip transmission line circuit 54, and is coupled to a power amplifier output 22 via an output matching transmission line circuit 56, both circuits 54, 56 being matched to 50Ω. Decoupling capacitors 58 are provided. The gate of transistor 50 is coupled to a biasing circuit, via circuit 54, which comprises a resistor 60 and bypass capacitor 62 coupled to a switch 64. Switch 64 provides a selectable value of gate voltage, namely -Vg (for normal amplifying operation), and -2Vg (for switching off transistor). Since bias voltage for a GaN device is negative (for example, - 3V), then to switch the device off, it is necessary to significantly increase this negative voltage by 2 or 3 times (for example, -6 V). The drain source current path of transistor 50 is coupled via circuit 56 to a voltage source Vdd 66, a bypass transistor 62 being provided.

As regards the impedance network 26, this is conveniently implemented by means of microstrip forming transmission lines. In particular, the phase offset half wavelength transmission line lengths 26, 30, 32 are conveniently constructed from microstrip, the length of the strip determining the phase variation (there is no significant impedance variation, since the ends of the strip are coupled to 50Ω impedances), and the width of the strip determining characteristic impedance of 50Ω. The network serves to provide a high output impedance of the transistor power amplifiers when they are turned off and to compensate for effect of the output matching elements and phase delays within the transistor power amplifiers. The chain of stubs 34, 36, 38 may be provided by a single length of microstrip, with nodes 33, 35, 37 being formed by shorting together the conductors of the microstrip. The stubs 34, 36, 38 are also important for stability, by suppressing to ground all potential low-frequency components, as well as for spectral purity by additional suppressing of second-harmonic components, for which a quarter-wavelength line becomes half wavelength.

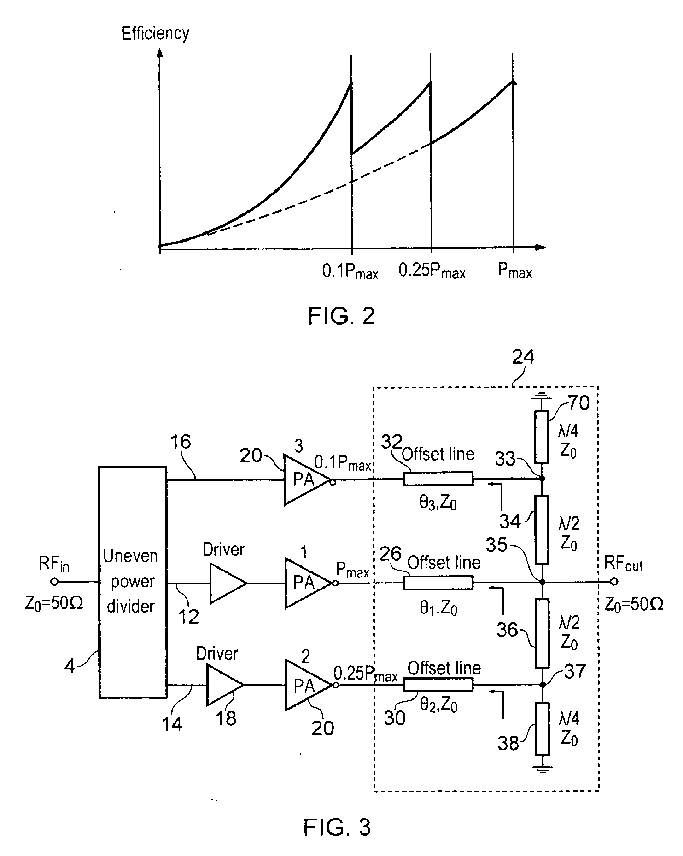

Thus in operation of the embodiment of Figure 1, transistor amplifier 20 may be selectively switched off by means of switch 64, and this has the effect of switching off the entire amplifying path 12. In operation of the amplifier of Figure 1, only a selected one of paths 12. 14, 16, will be switched on at any one time, the other two paths being switched off, in dependence on the anticipated traffic requirements for the base station in which the amplifier is situated. Figure 2 shows that the architecture with three power amplifiers can provide peak efficiencies at the three powers levels of the amplifying paths (maximum, -6 dB, and -10 dB).

In this architecture, an uneven power divider 4 is used at the input and one quarter-wavelength and two half-wavelength transmission lines 34, 36, 38 are used at the output. As a result, maximum power at maximum efficiency is realized when amplifying paths 14, 16 are switched off (bias is turned off), and amplifying path 12 is directly connected to the load. Since the quarter-wavelength transmission line 38 is grounded, the open-circuit condition is presented at the end of the combined line 34, 36, 38 with overall electrical length of 5λ/4 The maximum efficiency at 6 dB backoff power is achieved when amplifying paths 12, 16 are switched off, and amplifying path 14 is connected to the load through the half-wavelength line 34. Similarly, the maximum efficiency at 10 dB backoff is achieved when amplifying paths 12, 14 are switched off and amplifying path 16 is directly connected to the load through two half-wavelength lines 34, 36. To provide a high output impedance of the powers amplifiers when they are turned off and to compensate for effect of their output matching elements and phase delays, offset lines 26, 30, 32 are used in each amplifying path.

Referring now to the second embodiment shown in Figure 3, the embodiment of Figure 3 differs from that of Figure 1, principally in the arrangement of network 24, in that for convenience of physical implementation, the chain of transmission line stubs includes an additional quarter wavelength stub 70 coupled between ground and node 33. Amplifying path 16 is coupled to node 33, amplifying path 12 is coupled to node 35, and amplifying path 14 is coupled to node 37.

Referring now to the third embodiment shown in Figure 4, the embodiment is similar to the arrangement shown in Figure 3 of network 24. Amplifying path 16, providing 0.1 power, is provided by a switch connection 72 coupled to the output of driver amplifier 18 of amplifying path 12. Thus path 16, when switched on comprises driver amplifier 18 coupled via switch 72 to phase offset line 32. Offset line 32 is of a length to counter phase variations within driver amplifier 18. Driver amplifier 18 may be of similar form to that of power transistor amplifier 20, shown in figure 6, but with a smaller sized transistor, and without any bias switching arrangement. This arrangement reduces the number of amplifiers required, and only requires a two output uneven power divider 41 for amplifier paths 12, 14, but at the expense and complication of providing a switch 72.

The above described embodiments therefore provide a high amplifier efficiency at maximum power level and different backoff power levels due to a simple combining scheme which can be easily implemented into hybrid or monolithic integrated circuit. The embodiments provide high efficiency for RF power amplifiers at different levels of backoff output powers depending on the selected amplifying path. There is no need to use additional lossy switches at the output of the power amplifier to switch amplifying paths with different output powers. The embodiments provide significantly higher efficiency with the same linearity at different backoff output powers without needing additional switching or linearization techniques.

The description and drawings merely illustrate the principles of the invention. It will thus be appreciated that those skilled in the art will be able to devise various arrangements that, although not explicitly described or shown herein, embody the principles of the invention and are included within its spirit and scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. An RF power amplifier for mobile telecommunications including first, second and third amplifying paths (12, 14, 16), which provide respective first, second and third power output levels, which power output levels are different from each other, and switching means for selectively switching said amplifying paths, so that in operation, one of said amplifying paths is operative at any one time, and the others of said amplifying paths are inoperative,
wherein each of said amplifying paths has an input (6, 8, 10) and output and includes a transistor amplifier (18,20), a power divider means (4, 41) disposed between a power amplifier input and the inputs of said amplifying paths, the outputs of said amplifying paths being coupled through an impedance network (24) to a power amplifier output (28), wherein said impedance network includes a respective phase offset transmission line (26, 30, 32) coupled to the output of each amplifying path, for adjusting output phase values of the amplifying path, and the phase offset lines being coupled to said power amplifier output by way of at least one transmission line length (34, 36, 38; 70), said at least one transmission line length being arranged for coupling the amplifying path outputs to ground via an open circuit impedance.

2. A power amplifier according to claim 1, wherein said at least one transmission line length includes a quarter wave length (38, 70) connected to ground, and at least one half wavelength length (34, 36) coupled between the quarter wave length and the power amplifier output, with one or more phase offset lines connected to nodes (33, 35, 37) between the lengths.

3. A power amplifier according to claim 2, wherein said at least one transmission line length comprises a chain of transmission line lengths, with a quarter wave length (38) connected to ground, and first and second half wavelength lengths (34, 36) coupled between the quarter wave length and the power amplifier output, with phase offset lines connected to nodes (35, 37) between the lengths.

4. A power amplifier according to claim 2, wherein said at least one transmission line length comprise first and second chains of lengths, each chain comprising a quarter wavelength length (38, 70) connected to ground, and a half wavelength length (34, 36) coupled between the quarter wave length and the power amplifier output, with a phase offset line connected to a node (33, 37) between the quarter wavelength length and half wavelength length.

5. A power amplifier according to any preceding claim, wherein said power divider means comprises an unequal power divider (4), with first, second and third outputs coupled to respective inputs of the first, second and third amplifying paths, and providing levels of RF power input corresponding to the desired RF output levels of the respective amplifying paths.

6. A power amplifier according to any of claims 1 to 4, wherein said power divider comprises an unequal power divider (41), with a first output coupled to respective inputs of first and third amplifying paths (12, 16), and a second output being coupled to the input of a second amplifying path (14), wherein said first amplifying path includes a driver amplifier (18) and a main amplifier (20), and said third amplifying path comprises said driver amplifier and a switch means (72) coupled to the output of said driver amplifier.

7. A power amplifier according to any preceding claim, wherein said transistor amplifier includes an input impedance matching means (54) coupled to the input of a transistor, and an output impedance matching means (56) coupled to the output of the transistor, and including switching means (64) for selectively changing the bias voltage of the transistor, from an operative value to a value in which the transistor is switched off.

## Patentansprüche

1. HF-Leistungsverstärker für mobile Telekommunikation, mit einem ersten, einem zweiten und einem dritten Verstärkungspfad (12, 14, 16), welche jeweils einen ersten, einen zweiten und einen dritten Ausgangsleistungspegel bereitstellen, wobei die besagten Ausgangsleistungspegel voneinander unterschiedlich sind, und mit Umschaltmitteln zum selektiven Umschalten der besagten Verstärkungspfade, so dass, bei Betrieb, einer der besagten Verstärkungspfade zu jedem Zeitpunkt funktionsfähig ist, während die anderen der besagten Verstärkungspfade außer Betrieb sind,
wobei ein jeder der besagten Verstärkungspfade einen Eingang (6, 8, 10) und einen Ausgang aufweist und einen Transistorverstärker (18, 20) sowie ein Leistungsteilermittel (4, 41), welches zwischen einem Leistungsverstärkerausgang und den Eingängen der besagten Verstärkungspfade angeordnet ist, umfasst, wobei die Ausgänge der besagten Verstärkungspfade über ein Impedanznetzwerk (24) an einen Leistungsverstärkerausgang (28) gekoppelt sind, wobei das besagte Impedanznetzwerk eine jeweilige an den Ausgang eines jeden Verstärkungspfads gekoppelte phasenversetzte Übertragungsleitung (26, 30, 32) zum Anpassen der Ausgangsphasenwerte des Verstärkungspfads umfasst und die phasenversetzten Leitungen anhand mindestens einer Übertragungsleitungsteilstrecke (34, 36, 38, 70) an den besagten Leistungsverstärkerausgang gekoppelt sind, wobei die besagte mindestens eine Übertragungsleitungsteilstrecke für das Koppeln der Verstärkungspfadausgänge über eine Leerlaufimpedanz mit Masse verbunden ist, ausgelegt ist.

2. Leistungsverstärker nach Anspruch 1, wobei die besagte mindestens eine Übertragungsleitungsteilstrecke eine Viertelwellen-Teilstrecke (38, 70), welche mit Masse verbunden ist, und mindestens eine Halbwellenlängen-Teilstrecke (34, 36), welche zwischen der Viertelwellen-Teilstrecke und dem Leistungsverstärkerausgang gekoppelt ist, umfasst, wobei eine oder mehrere phasenversetzte Leitungen an Knoten (33, 35, 37) zwischen den Teilstrecken angeschlossen sind.

3. Leistungsverstärker nach Anspruch 2, wobei die besagte mindestens eine Übertragungsleitungsteilstrecke eine Kette von Übertragungsleitungsteilstrecken umfasst, wobei eine Viertelwellen-Teilstrecke (38) mit Masse verbunden ist, und eine erste und eine zweite Halbwellenlängen-Teilstrecke (34, 36) zwischen der Viertelwellenlänge und dem Leistungsverstärkerausgang gekoppelt ist, wobei phasenversetzte Leitungen an Knoten (35, 37) zwischen den Teilstrecken gekoppelt sind.

4. Leistungsverstärker gemäß Anspruch 2, wobei die besagte mindestens eine Übertragungsleitungsteilstrecke eine erste und eine zweite Kette von Teilstrecken umfasst, wobei jede Kette eine mit Masse verbundene Viertelwellenlängen-Teilstrecke (38, 70) und eine zwischen der Viertelwellen-Teilstrecke und dem Leistungsverstärkerausgang gekoppelte Halbwellenlängen-Teilstrecke (34,36) aufweist, wobei eine phasenversetzte Leitung an einen Knoten (33, 37) zwischen angeschlossen ist.

5. Leistungsverstärker nach einem beliebigen der vorstehenden Ansprüche, wobei das besagte Leistungsteilermittel einen ungleichen Leistungsteiler (4) mit einem ersten, einem zweiten und einem dritten Ausgang, welche an entsprechende Eingänge des ersten, zweiten und dritten Verstärkungspfads angeschlossen sind und den gewünschten HF-Ausgangspegeln der jeweiligen Verstärkerpfade entsprechende RF-Leistungseingangspegel bereitstellen, umfasst.

6. Leistungsverstärker nach einem beliebigen der Ansprüche 1 bis 4, wobei der besagte Leistungsteiler einen ungleichen Leistungsteiler (41) mit einem ersten Ausgang, welcher an jeweilige Eingänge des ersten und dritten Verstärkerpfads (12, 16) gekoppelt ist, und einem zweiten Ausgang, welcher an den Eingang eines zweiten Verstärkerpfads (14) gekoppelt ist, wobei der besagte erste Verstärkerpfad einen Treiberverstärker (18) und einen Hauptverstärker (20) umfasst, und wobei der besagte dritte Verstärkerpfad den besagten Treiberverstärker und ein Umschaltmittel (72) umfasst, welches an den Ausgang des besagten Treiberverstärkers angeschlossen ist.

7. Leistungsverstärker nach einem beliebigen der vorstehenden Ansprüche, wobei der besagte Transistorverstärker ein an den Eingang eines Transistors gekoppeltes Eingangsimpedanzanpassungsmittel (54) und ein an den Ausgangs des Transistor gekoppeltes Ausgangsimpedanzanpassungsmittel (56) umfasst, und umfassend ein Umschaltmittel (64) zum selektiven Wechsel der Biasspannung des Transistors von einem operativen Wert zu einem Wert, in welchem der Transistor ausgeschaltet ist.

## Revendications

1. Amplificateur de puissance RF pour des télécommunications mobiles comprenant les première, deuxième et troisième voies d'amplification (12, 14, 16), qui fournissent les premier, deuxième et troisième niveaux de sortie de puissance respectifs, lesquels niveaux de sortie de puissance sont différents les uns des autres, et des moyens de commutation pour commuter sélectivement lesdites voies d'amplification, de sorte qu'en fonctionnement, une desdites voies d'amplification soit opérationnelle à tout moment, et que les autres parmi lesdites voies d'amplification soient inopérantes,
dans lequel chacune desdites voies d'amplification présente une entrée (6, 8, 10) et une sortie et comprend un amplificateur à transistors (18, 20), un moyen diviseur de puissance (4, 41) disposé entre une entrée de l'amplificateur de puissance et les entrées desdites voies d'amplification, les sorties desdites voies d'amplification étant couplées par l'intermédiaire d'un réseau d'impédance (24) à une sortie de l'amplificateur de puissance (28), dans lequel ledit réseau d'impédance comprend une ligne de transmission de déphasage respective (26, 30, 32) couplée à la sortie de chaque voie d'amplification, pour régler des valeurs de phase de sortie de la voie d'amplification, et les lignes de déphasage étant couplées à ladite sortie de l'amplificateur de puissance au moyen d'au moins une longueur de ligne de transmission (34, 36, 38 ; 70), ladite au moins une longueur de ligne de transmission étant conçue pour coupler les sorties de voie d'amplification à la masse par le biais d'une impédance en circuit ouvert.

2. Amplificateur de puissance selon la revendication 1, dans lequel ladite au moins une longueur de ligne de transmission comprend un quart de longueur d'onde (38, 70) relié à la masse, et au moins une demie longueur d'onde (34, 36) couplée entre le quart de longueur d'onde et la sortie de l'amplificateur de puissance, une ou plusieurs lignes de déphasage étant connectées aux noeuds (33, 35, 37) entre les longueurs.

3. Amplificateur de puissance selon la revendication 2, dans lequel ladite au moins une longueur de ligne de transmission comprend une chaîne de longueurs de ligne de transmission, un quart de longueur d'onde (38) étant connecté à la masse et les première et deuxième demies longueurs d'onde (34, 36) étant couplées entre le quart de longueur d'onde et la sortie de l'amplificateur de puissance, les lignes de déphasage étant connectées aux noeuds (35, 37) entre les longueurs.

4. Amplificateur de puissance selon la revendication 2, dans lequel ladite au moins une longueur de ligne de transmission comprend des première et deuxième chaînes de longueurs, chaque chaîne comprenant un quart de longueur d'onde (38, 70) connecté à la masse, et une demie longueur d'onde (34, 36) couplée entre le quart de longueur d'onde et la sortie de l'amplificateur de puissance, une ligne de déphasage étant connectée à un noeud (33, 37) entre le quart de longueur d'onde et la demie longueur d'onde.

5. Amplificateur de puissance selon l'une quelconque des revendications précédentes, dans lequel ledit moyen diviseur de puissance comprend un diviseur de puissance inégale (4), les première, deuxième et troisième sorties étant couplées à des entrées respectives des première, deuxième et troisième voies d'amplification, et fournissant des niveaux d'entrée de puissance RF correspondant aux niveaux de sortie RF souhaités des voies d'amplification respectives.

6. Amplificateur de puissance selon l'une quelconque des revendications 1 à 4, dans lequel ledit diviseur de puissance comprend un diviseur de puissance inégale (41), une première sortie étant couplée à des entrées respectives des première et troisième voies d'amplification (12, 16), et une deuxième sortie étant couplée à l'entrée d'une deuxième voie d'amplification (14), dans lequel ladite première voie d'amplification comprend un amplificateur de commande (18) et un amplificateur principal (20), et ladite troisième voie d'amplification comprend ledit amplificateur de commande et un moyen de commutation (72) couplé à la sortie dudit amplificateur de commande.

7. Amplificateur de puissance selon l'une quelconque des revendications précédentes, dans lequel ledit amplificateur à transistors comprend un moyen d'adaptation d'impédance d'entrée (54) couplé à l'entrée d'un transistor, et un moyen d'adaptation d'impédance de sortie (56) couplé à la sortie du transistor, et comprenant des moyens de commutation (64) pour faire passer sélectivement la tension de polarisation du transistor d'une valeur opérationnelle à une valeur dans laquelle le transistor est désactivé.
